# EUROPÄISCHE PATENTSCHRIFT

(11) **EP 4 189 738 B1**
(45) Veröffentlichungstag und Bekanntmachung des Hinweises auf die Patenterteilung: **01.07.2026**
(21) Anmeldenummer: 21749564.7
(22) Anmeldetag: 22.07.2021
(51) Int. Cl.: H01L 23/498, H01L 23/15, H01L 23/538

(54) **ELEKTRONISCHES SCHALTUNGSMODUL**
ELECTRONIC CIRCUIT MODULE
MODULE DE CIRCUIT ÉLECTRONIQUE

(30) Priorität: 03.08.2020 DE 102020209752
(43) Veröffentlichungstag der Anmeldung: 07.06.2023
(73) Patentinhaber: Robert Bosch GmbH, 70442 Stuttgart (DE)
(72) Erfinder: FOERSTER, Christian, 72768 Reutlingen (DE); HOMOTH, Jan, 72770 Reutlingen (DE); SONNTAG, Thomas, 72768 Reutlingen (DE)
(86) Internationale Anmeldenummer: PCT/EP2021/070585
(87) Internationale Veröffentlichungsnummer: WO 2022/028915

(56) Entgegenhaltungen:
- EP-A1- 3 547 359
- WO-A2-2005/013363
- DE-A1- 102008 040 906
- US-A1- 2011 148 545
- US-A1- 2014 342 679

## Beschreibung

Die Erfindung betrifft ein elektronisches Schaltungsmodul. Gegenstand der vorliegenden Erfindung ist auch ein Verfahren zur Herstellung eines mehrlagigen LTCC-Schaltungsträgers für ein solches elektronisches Schaltungsmodul.

Aus dem Stand der Technik sind Leistungsmodule bekannt, bei welchen Siliziumkarbidleistungshalbleiter (SiC-Leistungshalbleiter) als MOSFET-Leistungsschalter ausgeführt sind und zunächst mittels Silbersintern auf ein AMB-Substrat (AMB: Active Metal Brazed) montiert werden, wobei Silbersintern ein spezieller AVT-Prozess (AVT: Aufbau- und Verbindungstechnik) mit niedriger Sintertemperatur von < 300°C ist. Anschließend wird auf die SiC-Leistungshalbleiter wieder durch das Silbersintern ein Lotplättchen aufgesintert. Auf dieses Lotplättchen wird wiederum ein Lot aufgebracht, welches anschließend zum Verlöten mit einer Seite eines mehrlagigen LTCC-Mehrlagensubstrat dient. D.h. nachdem die SiC-Leistungshalbleiter auf das AMB-Substrat gesintert wurden, folgen weitere vier Prozessschritte, bis auch das LTCC-Mehrlagensubstrat angeschlossen wurde.

Aus der WO 2005/013363 A2 ist eine Schaltungsanordnung auf einem Substrat mit mindestens einem auf dem Substrat angeordneten Halbleiterbauelement mit mindestens einer elektrischen Kontaktfläche und mindestens einer auf dem Substrat angeordneten Verbindungsleitung zur elektrischen Kontaktierung der Kontaktfläche des Halbleiterbauelements bekannt. Hierbei ist die elektrische Verbindungsleitung ein Bestandteil mindestens eines auf dem Substrat angeordneten, diskreten, passiven elektrischen Bauelements. Das diskrete, passive elektrische Bauelement ist beispielsweise ein Kondensator, eine Spule oder ein elektrischer Widerstand oder ein Sensor.

Aus der EP 3 547 359 A1 ist ein vorgepacktes Leistungsmodul bekannt, welches einen in einen elektrisch isolierenden Kern eingebetteten Leistungschip, zwei erste elektrisch leitende Schichten, welche in den elektrisch isolierenden Kern eingebettet sind und erste Kontaktpads aufweisen, welche jeweils über erste Durchkontaktierungen mit dem Leistungschip verbunden sind, zwei zweite elektrisch leitende Schichten, welche auf gegenüberliegenden Hauptoberflächen des Kerns angeordnet sind und zweite Kontaktpads umfassen, welche jeweils über zweite Durchkontaktierungen mit den ersten Kontaktpads der jeweiligen ersten elektrisch leitenden Schicht verbunden sind. Hierbei weisen die zweiten leitenden Schichten eine größer Dicke als die ersten leitenden Schichten auf. Ein Oberflächenbereich eines Kontaktpads einer der ersten Schichten ist größer als der Oberflächenbereich des elektrischen Kontakts des Leistungschips. Der Oberflächenbereich eines Kontaktpads einer der zweiten Schichten ist größer oder gleich des Oberflächenbereichs des Kontaktpads der ersten elektrisch leitenden Schicht, mit welcher es verbunden ist.

Aus der DE 10 2016 202 669 A1 ist ein elektronisches Schaltungsmodul mit einem mehrlagigen LTCC-Schaltungsträger aus strukturierten anorganischen Substratlagen, welche zur elektrischen und/oder thermischen Leitung elektrische und/oder thermische Leitungsstrukturen aufweisen, mindestens einem elektronischen Bauteil, welches auf einer ersten Seite und/oder einer gegenüberliegenden zweiten Seite des LTCC-Schaltungsträgers angeordnet ist, und mindestens einem SiC-Leistungshalbleiter sowie ein gattungsgemäßes Verfahren zur Herstellung eines solchen LTCC-Schaltungsträgers bekannt. Hierbei ist eine partielle Metallisierung der elektrischen und/oder thermischen Leitungsstrukturen als Einlegeteil ausgeführt, welche ein korrespondierendes in eine der anorganischen Substratlagen eingebrachtes Formloch ausfüllt. Bei der Herstellung des LTCC-Schaltungsträgers wird in mindestens eine ungebrannte Rohmateriallage mindestens ein Formloch für ein korrespondierendes Einlegeteil eingebracht. Anschließend wird das Einlegeteil in das Formloch eingelegt und die Rohmateriallage mit dem Einlegeteil in einem Constraint-Sintering-Prozess zu einer korrespondierenden anorganischen Substratlage gebrannt. Im Constraint-Sintering-Prozess beschränkt sich eine Materialschrumpfung im Wesentlichen auf die Dicke der Rohmateriallage, so dass die korrespondierende anorganische Substratlage dünner als die Rohmateriallage ist.

### Offenbarung der Erfindung

Das elektronische Schaltungsmodul mit den Merkmalen des unabhängigen Patentanspruchs 1 hat den Vorteil, dass mindestens ein Siliziumkarbidleistungshalbleiter (SiC-Leistungshalbleiter) bereits bei der Herstellung eines LTCC-Schaltungsträgers in diesen eingebettet bzw. integriert wird. Durch die Einbettung des SiC-Leistungshalbleiters in den LTCC-Schaltungsträger wird die Kontaktierung des mindestens einen SiC-Leistungshalbleiters im Inneren des LTCC-Schaltungsträgers umgesetzt und ist somit vor äußeren Einflüssen geschützt. Dadurch können die Anschlusskontakte des SiC-Leistungshalbleiters auf einer Vorderseite und/oder Rückseite des SiC-Leistungshalbleiters einfacher und deutlich kostengünstiger gestaltet werden. Des Weiteren kann die räumliche Positionierung der SiC-Leistungshalbleiter deutlich exakter durchgeführt werden. Nach der Erfindung schließt der Halbleiter exakt bündig mit einer Unterseite und einer Oberseite des LTCC-Schaltungsträgers ab oder ist vollständig im Inneren des LTCC-Schaltungsträgers eingebettet. Auch ein definierter Überstand nach unten oder oben ist möglich. Durch die hohe Sintertemperatur von 900 °C sind die elektrischen und/oder thermischen Verbindungen innerhalb des LTCC-Schaltungsträgers weitaus temperaturbeständiger als eine bei niedrigeren Temperaturen realisierte Löt- und/oder Silbersinterverbindung. Da der LTCC-Schaltungsträger und der mindestens eine SiC-Leistungshalbleiter aus keramischen Werkstoffen bestehen, weisen diese den annähernd gleichen Ausdehnungskoeffizienten auf. Dadurch ist die beschriebene Integration des mindestens einen SiC-Leistungshalbleiters direkt im Herstellprozess des LTCC-Schaltungsträgers realisierbar. Dies ermöglicht das optimale Abstimmen der metallischen Funktionsanschlüsse und der nach folgenden Prozessketten mit entsprechend großen Einsparpotentialen.

Ausführungsformen der vorliegenden Erfindung stellen ein elektronisches Schaltungsmodul mit einem mehrlagigen LTCC-Schaltungsträger aus strukturierten anorganischen Substratlagen, welche zur elektrischen und/oder thermischen Leitung elektrische und/oder thermische Leitungsstrukturen aufweisen, mindestens einem elektronischen Bauteil, welches auf einer ersten Seite und/oder einer gegenüberliegenden zweiten Seite des LTCC-Schaltungsträgers angeordnet ist, und mindestens einem SiC-Leistungshalbleiter zur Verfügung. Hierbei ist der mindestens eine SiC-Leistungshalbleiter in den mehrlagigen LTCC-Schaltungsträger eingebettet und zumindest an drei Seiten von dem mehrlagigen LTCC-Schaltungsträger umschlossen, wobei Anschlusskontakte des SiC-Leistungshalbleiter mit den elektrischen und/oder thermischen Leitungsstrukturen des LTCC-Schaltungsträgers kontaktiert sind. Eine erste Seite des mindestens einen SiC-Leistungshalbleiters ist einer ersten Seite des mehrlagigen LTCC-Schaltungsträgers zugewandt, und eine zweite Seite des mindestens einen SiC-Leistungshalbleiters ist einer zweiten Seite des mehrlagigen LTCC-Schaltungsträgers zugewandt. So kann die erste Seite des mindestens einen SiC-Leistungshalbleiters seiner Oberseite und die zweite Seite seiner Rückseite entsprechen. Analog kann die erste Seite des mehrlagigen LTCC-Schaltungsträgers seiner Oberseite und die zweite Seite seiner Unterseite entsprechen. Die erste Seite bzw. Oberseite schließt bündig mit der ersten Seite bzw. Oberseite des mehrlagigen LTCC-Schaltungsträgers ab. Alternativ schließt die zweite Seite bzw. Rückseite des mindestens einen SiC-Leistungshalbleiters bündig mit der zweiten Seite bzw. Rückseite des mehrlagigen LTCC-Schaltungsträgers ab. Dadurch ist eine einfache elektrische und/oder thermische Kontaktierung des mindestens einen SiC-Leistungshalbleiters mit externen Baugruppen oder Geräten möglich. So können beispielsweise Steuergeräte oder elektrische Verbraucher, wie beispielsweise Elektromotoren, direkt mit entsprechenden Anschlusskontakten des mindestens einen SiC-Leistungshalbleiters kontaktiert werden. Zusätzlich können Kühlvorrichtungen, wie beispielsweise Kühlkörper, über eine thermisch gut leitende aber elektrisch isolierende Isolierschicht mit den entsprechenden Anschlusskontakten des mindestens einen SiC-Leistungshalbleiters kontaktiert werden.

Zudem wird ein Verfahren zur Herstellung eines mehrlagigen LTCC-Schaltungsträgers für ein solches elektronisches Schaltungsmodul vorgeschlagen. Hierbei wird in mindestens eine Rohsubstratlage mit elektrischen und/oder thermischen Leitungsstrukturen mindestens eine Aussparung für einen korrespondierenden SiC-Leistungshalbleiter eingebracht, wobei mehrere Rohsubstratlagen gestapelt und mindestens ein SiC-Leistungshalbleiter in die mindestens eine Aussparung eingelegt wird. Der Rohsubstratstapel mit dem SiC-Leistungshalbleiter wird unter Druck und Temperatur laminiert. Der laminierte Rohsubstratstapel wird in einem druckunterstützten Sinterprozess zu dem mehrlagigen LTCC-Schaltungsträger mit dem eingebetteten SiC-Leistungshalbleiter geschrumpft, wobei Anschlusskontakte des SiC-Leistungshalbleiters durch den druckunterstützten Sinterprozess mit den elektrischen und/oder thermischen Leitungsstrukturen von anorganischen Substratlagen kontaktiert werden, welche durch den druckunterstützten Sinterprozess aus den Rohsubstratlagen mit elektrischen und/oder thermischen Leitungsstrukturen erzeugt werden.

Durch die in den abhängigen Ansprüchen aufgeführten Maßnahmen und Weiterbildungen sind vorteilhafte Verbesserungen des im unabhängigen Patentanspruch 1 angegebenen elektronischen Schaltungsmoduls und des im unabhängigen Patentanspruch 9 angegebenen Verfahrens zur Herstellung eines mehrlagigen Schaltungsträgers für ein solches elektronisches Schaltungsmodul möglich.

In vorteilhafter Ausgestaltung des elektronischen Schaltungsmoduls kann der mindestens eine SiC-Leistungshalbleiter eine korrespondierende Aussparung ausfüllen, welche in mindestens eine anorganische Substratlage eingebracht ist. Dadurch kann der mindestens eine SiC-Leistungshalbleiters sowohl an seiner Oberseite als auch an seiner Unterseite einfach elektrisch und/oder thermisch mit entsprechenden elektrisch und/oder thermisch leitenden Konturen kontaktiert werden, welche an einer Unterseite einer direkt oberhalb des mindestens einen SiC-Leistungshalbleiters angeordneten Substratlage oder an einer Oberseite einer direkt unterhalb des mindestens einen SiC-Leistungshalbleiters angeordneten Substratlage ausgebildet sind.

In weiterer vorteilhafter Ausgestaltung des elektronischen Schaltungsmoduls kann mindestens ein Anschlusskontakt auf der ersten Seite oder auf der zweiten Seite des mindestens einen SiC-Leistungshalbleiters über eine Durchkontaktierung elektrisch mit einem Anschlusskontakt, welcher auf der ersten Seite oder auf der zweiten Seite des mehrlagigen LTCC-Schaltungsträgers angeordnet ist, oder mit einem elektronischen Bauteil verbunden werden, welches auf der ersten Seite oder auf der zweiten Seite des mehrlagigen LTCC-Schaltungsträgers angeordnet ist. So kann der mindestens eine SiC-Leistungshalbleiter über Durchkontaktierungen beispielsweise mit einem als Logikschaltkreis ausgeführtem elektronischen Bauteil und/oder mit einem als diskretes Bauteil ausgeführten elektronischen Bauteil elektrisch kontaktiert werden, welche auf der Oberseite oder auf der Unterseite des LTCC-Schaltungsträgers angeordnet sind. Hierbei kann das diskrete Bauteil beispielsweise ein ohmscher Widerstand, eine elektrische Spule oder ein elektrischer Kondensator sein.

In weiterer vorteilhafter Ausgestaltung des elektronischen Schaltungsmoduls kann eine Hochstromleiterbahn in den mehrlagigen LTCC-Schaltungsträger eingebettet und über mindestens eine erste Durchkontaktierung mit einem korrespondierenden Anschlusskontakt auf der ersten Seite oder auf der zweiten Seite des mehrlagigen Schaltungsträgers elektrisch verbunden werden. Zudem kann die Hochstromleiterbahn über mindestens eine zweite Durchkontaktierung mit einem korrespondierenden Anschlusskontakt auf der ersten Seite oder auf der zweiten Seite des mindestens einen SiC-Leistungshalbleiters elektrisch verbunden werden. Alternativ kann die Hochstromleiterbahn über eine Kontaktfläche flächig mit einem korrespondierenden Anschlusskontakt auf der ersten Seite oder auf der zweiten Seite des mindestens einen SiC-Leistungshalbleiters elektrisch verbunden werden. Durch die Hochstromleiterbahn können auch hohe Ströme von deutlich über 20A innerhalb des LTCC-Schaltungsträgers weitergeleitet werden. Dadurch können Ausführungsformen des erfindungsgemäßen Schaltungsträgers in Fahrzeugen oder stationären Anlagen für elektrische Leistungsendstufen mit integrierter Logik eingesetzt werden.

In weiterer vorteilhafter Ausgestaltung des elektronischen Schaltungsmoduls kann ein Anschlusskontakt auf der ersten Seite bzw. Oberseite oder auf der zweiten Seite bzw. Rückseite des mindestens einen SiC-Leistungshalbleiters flächig mit einem thermisch und elektrisch leitenden Einlegeteil oder mit einer thermisch und elektrisch leitenden gedruckten Dickschichtstruktur kontaktiert werden. Hierbei kann das Einlegeteil oder die gedruckte Dickschichtstruktur bündig mit der ersten Seite bzw. Oberseite oder mit der zweiten Seite bzw. Rückseite des mehrlagigen LTCC-Schaltungsträgers abschließen. Dadurch ist eine flächige elektrische und/oder thermische Kontaktierung des mindestens einen SiC-Leistungshalbleiters mit externen Baugruppen oder Geräten möglich.

Alternativ kann der mindestens eine SiC-Leistungshalbleiter an allen vier Seiten von dem mehrlagigen LTCC-Schaltungsträger umschlossen sein. Das bedeutet, dass der mindestens eine SiC-Leistungshalbleiter vollständig in den LTCC-Schaltungsträger integriert ist.

In weiterer vorteilhafter Ausgestaltung des elektronischen Schaltungsmoduls kann der mindestens eine SiC-Leistungshalbleiter beispielsweise als MOSFET-Leistungsschalter ausgebildet werden.

In vorteilhafter Ausgestaltung des Verfahrens kann vor dem Stapeln der Rohsubstratlagen mindestens eine weitere Aussparung in mindestens eine Rohsubstratlage eingebracht werden, in welche während oder nach dem Stapeln mindestens eine Durchkontaktierung und/oder mindestens eine Hochstromleiterbahn und/oder mindestens ein thermisch und elektrisch leitendes Einlegeteil als zusätzliche elektrische Leitungsstruktur eingelegt und/oder mindestens eine thermisch und elektrisch leitende Dickschichtstruktur als zusätzliche elektrische Leitungsstruktur gedruckt werden kann. Dadurch können die an den Oberseiten oder Rückseiten der Rohsubstratlagen ausgebildeten elektrisch und/oder thermisch leitenden Leitungsstrukturen miteinander oder mit den Anschlusskontakten auf der ersten Seite bzw. Oberseite oder der zweiten Seite bzw. Rückseite des LTCC-Schaltungsträgers kontaktiert werden.

In weiterer vorteilhafter Ausgestaltung des Verfahrens kann der druckunterstützte Sinterprozess die Rohsubstratlage in der Dicke schrumpfen, so dass die erzeugte Substratlage dünner als die Rohsubstratlage ist. Zudem kann eine Höhe einer Aussparung, welche in mindestens eine der Rohsubstratlagen eingebracht wird, höher als der SiC-Leistungshalbleiter ausgeführt werden, wobei die Höhe der Aussparung in der mindestens einen Rohsubstratlage so gewählt werden kann, dass die Höhe einer geschrumpften Aussparung in der mindestens einen geschrumpften Substratlage der Höhe des SiC-Leistungshalbleiters entspricht und der mindestens eine SiC-Leistungshalbleiter die korrespondierende geschrumpfte Aussparung ausfüllt. Dadurch schrumpfen die Substratlagen des LTCC-Schaltungsträgers passgenau auf den mindestens einen SiC-Leistungshalbleiters auf. Hierbei kommen die elektrisch und/oder thermisch leitenden Leitungsstrukturen sowie Leiterbahnen und Durchkontaktierungen in Berührung mit den auf dem mindestens einen SiC-Leistungshalbleiter vorhandenen Anschlusskontakten, so dass es auch zum Versintern der elektrisch und/oder thermisch leitenden Leitungsstrukturen sowie Leiterbahnen und Durchkontaktierungen mit den Anschlusskontakten des mindestens einen SiC-Leistungshalbleiters kommt und eine stabile elektrische Verbindung mit ohmschen Kontakten entsteht.

Ausführungsbeispiele der Erfindung sind in der Zeichnung dargestellt und werden in der nachfolgenden Beschreibung näher erläutert. In der Zeichnung bezeichnen gleiche Bezugszeichen Komponenten bzw. Elemente, die gleiche bzw. analoge Funktionen ausführen.

Kurze Beschreibung der Zeichnungen
Fig. 1 zeigt eine schematische Schnittdarstellung eines Ausschnitts eines Ausführungsbeispiels eines LTCC-Schaltungsträgers während eines erfindungsgemäßen Verfahrens zur Herstellung eines mehrlagigen LTCC-Schaltungsträgers für ein erfindungsgemäßes elektronisches Schaltungsmodul zu verschiedenen Zeitpunkten.
Fig. 2 zeigt eine schematische Schnittdarstellung eines ersten Ausführungsbeispiels eines erfindungsgemäßen elektronischen Schaltungsmoduls.
Fig. 3 zeigt eine schematische Schnittdarstellung eines zweiten Ausführungsbeispiels eines erfindungsgemäßen elektronischen Schaltungsmoduls.
Fig. 4 zeigt eine schematische Schnittdarstellung eines dritten Ausführungsbeispiels eines erfindungsgemäßen elektronischen Schaltungsmoduls.
Fig. 5 zeigt eine schematische Schnittdarstellung eines vierten Ausführungsbeispiels eines erfindungsgemäßen elektronischen Schaltungsmoduls.

Ausführungsformen der Erfindung

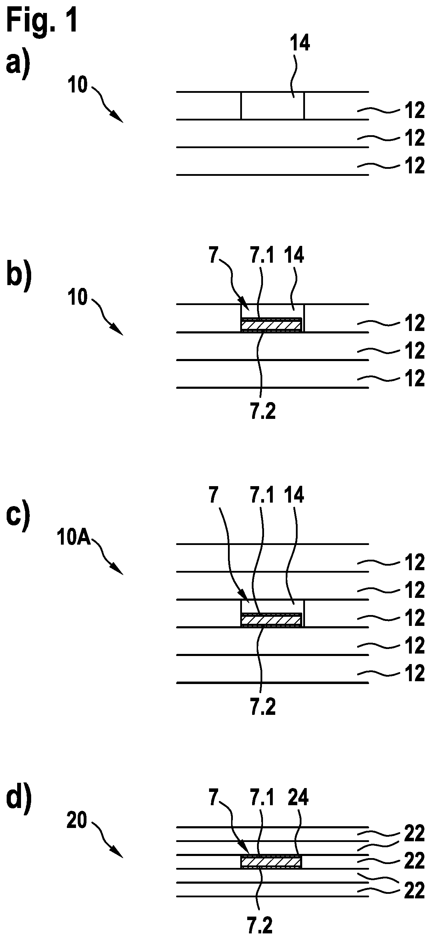

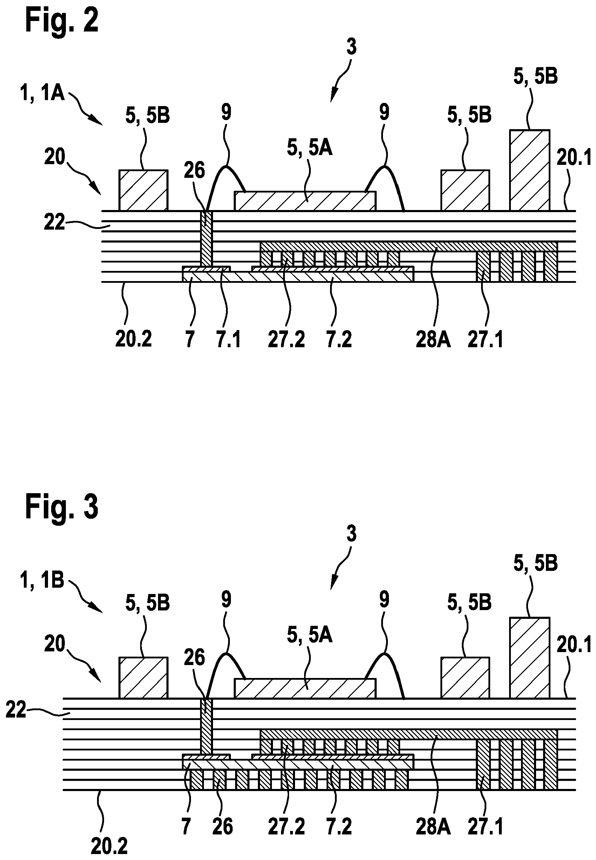

Bei dem erfindungsgemäßen Verfahren zur Herstellung eines mehrlagigen LTCC-Schaltungsträgers 20 für ein erfindungsgemäßes elektronisches Schaltungsmodul 1, 1A, 1B, 1C, 1D 1, welches in Fig. 2 bis 4 dargestellt ist, wird in mindestens eine Rohsubstratlage 12 mit elektrischen und/oder thermischen Leitungsstrukturen mindestens eine Aussparung 14 für einen korrespondierenden SiC-Leistungshalbleiter 7 eingebracht, wobei mehrere Rohsubstratlagen 12 zu einem in Fig. 1 a) dargestellten Rohsubstratstapel 10 gestapelt werden. Die Aussparung 14 ist größer, insbesondere höher als der mindestens eine SiC-Leistungshalbleiter 7, und kann beispielsweise durch Stanzen in die mindestens eine Rohsubstratlage 12 eingebracht werden. Die Rohsubstratlage 12 ist vorzugsweise als Folie ausgeführt, an deren Oberseite und Unterseite vorgegebene nicht näher bezeichnete elektrisch und/oder thermisch leitenden Leitungsstrukturen aufgebracht sind. Während des Aufstapelns des Rohsubstratstapels 10 wird der mindestens eine SiC-Leistungshalbleiter in der korrespondierenden Aussparung 14 lagerichtig platziert, wie aus Fig. 1 b) ersichtlich ist. Der Rohsubstratstapel 10 mit dem eingelegten SiC-Leistungshalbleiter 7 wird unter Druck und Temperatur laminiert, so dass die einzelnen Rohsubstratlage 12 "verkleben" und ein in Fig. 1 c) dargestellter laminierter Rohsubstratstapel 10A entsteht. Durch den prinzipbedingten Aufbau eines solchen mehrlagigen LTCC-Schaltungsträgers ist der mindestens eine SiC-Leistungshalbleiter im dargestellten Ausführungsbeispiel vollständig in dem laminierten Rohsubstratstapel 10 eingebettet und damit geschützt. Der laminierte Rohsubstratstapel 10A wird in einem druckunterstützten Sinterprozess zu dem in Fig. 1 d) dargestellten mehrlagigen LTCC-Schaltungsträger 20 mit dem eingebetteten SiC-Leistungshalbleiter 7 geschrumpft. Hierbei werden die Anschlusskontakte des SiC-Leistungshalbleiters 7 durch den druckunterstützten Sinterprozess mit den elektrischen und/oder thermischen Leitungsstrukturen von anorganischen Substratlagen 22 kontaktiert, welche durch den druckunterstützten Sinterprozess aus den Rohsubstratlagen 12 mit elektrischen und/oder thermischen Leitungsstrukturen erzeugt werden.

Wie aus Fig. 1 weiter ersichtlich ist, schrumpft der druckunterstützte Sinterprozess die Rohsubstratlage 12 in der Dicke bzw. Höhe, so dass die erzeugte Substratlage 22 dünner als die Rohsubstratlage 12 ist. Wie aus Fig. 1 b) weiter ersichtlich ist, wird eine Höhe der Aussparung 14, welche in mindestens eine der Rohsubstratlagen 12 eingebracht ist, höher als der SiC-Leistungshalbleiter 7 ausgeführt, wobei die Höhe der Aussparung 14 in der mindestens einen Rohsubstratlage 12 so gewählt wird, dass die Dicke bzw. Höhe einer geschrumpften Aussparung 24 in der mindestens einen geschrumpften Substratlage 22 der Dicke bzw. Höhe des SiC-Leistungshalbleiters 7 entspricht und die geschrumpfte Aussparung 24 ausfüllt, wie aus Fig. 1 d) ersichtlich ist. Zudem wird vor dem Stapeln der Rohsubstratlagen mindestens eine weitere Aussparung in mindestens eine Rohsubstratlage 12 eingebracht, in welche während oder nach dem Stapeln mindestens eine Durchkontaktierung 26, 27.1, 27.2 und/oder mindestens eine Hochstromleiterbahn 28A, 28B und/oder mindestens ein thermisch und elektrisch leitendes Einlegeteil als zusätzliche elektrische Leitungsstruktur eingelegt wird und/oder mindestens eine thermisch und elektrisch leitende Dickschichtstruktur 29 in die weitere Aussparung gedruckt wird.

Wie aus Fig. 2 bis 5 ersichtlich ist, umfassen die dargestellten Ausführungsbeispiele eines erfindungsgemäßen elektronischen Schaltungsmoduls 1 jeweils einen mehrlagigen LTCC-Schaltungsträger 20 aus strukturierten anorganischen Substratlagen 22, welche zur elektrischen und/oder thermischen Leitung elektrische und/oder thermische Leitungsstrukturen aufweisen, mindestens ein elektronisches Bauteil 5, welches auf einer ersten Seite 20.1 und/oder einer gegenüberliegenden zweiten Seite 20.2 des LTCC-Schaltungsträgers 20 angeordnet ist, und mindestens einen SiC-Leistungshalbleiter 7. Hierbei ist der mindestens eine SiC-Leistungshalbleiter 7 in den mehrlagigen LTCC-Schaltungsträger 20 eingebettet und zumindest an drei Seiten von dem mehrlagigen LTCC-Schaltungsträger 20 umschlossen ist, wobei Anschlusskontakte des SiC-Leistungshalbleiter 7 mit den elektrischen und/oder thermischen Leitungsstrukturen des LTCC-Schaltungsträgers 20 kontaktiert sind. Der mehrlagige LTCC-Schaltungsträger 20 ist nach dem oben beschriebenen Verfahren hergestellt.

In den dargestellten Ausführungsbeispielen ist das elektronische Schaltungsmodul 1, 1A, 1B, 1C, 1D beispielhaft als Leistungsmodul 3 ausgeführt, und der mindestens eine SiC-Leistungshalbleiter 7 ist als MOSFET-Leistungsschalter ausgebildet.

Wie aus Fig. 2 bis 5 weiter ersichtlich ist, ist eine erste Seite 7.1, hier Oberseite, des mindestens einen SiC-Leistungshalbleiters 7 einer ersten Seite 20.1, hier Oberseite, des mehrlagigen LTCC-Schaltungsträgers 20 zugewandt, und eine zweite Seite 7.2, hier Rückseite, des mindestens einen SiC-Leistungshalbleiters 7 ist einer zweiten Seite 20.2, hier Rückseite, des mehrlagigen LTCC-Schaltungsträgers 20 zugewandt. Zudem entspricht die Stärke bzw. Höhe oder Dicke des mindestens einen SiC-Leistungshalbleiter 7 der Stärke bzw. Höhe oder Dicke der korrespondierenden Aussparung 24 in der mindestens einen anorganischen Substratlage 22.

Wie aus Fig. 2 bis 4 weiter ersichtlich ist, ist im dargestellten Ausschnitt der Ausführungsbeispiele des elektronischen Schaltungsmoduls 1, 1A, 1B, 1C, 1D jeweils mindestens ein Anschlusskontakt auf der ersten Seite 7.1 bzw. Oberseite des mindestens einen SiC-Leistungshalbleiters 7 über eine Durchkontaktierung 26 elektrisch mit einem Anschlusskontakt auf der ersten Seite 20.1 bzw. Oberseite des mehrlagigen LTCC-Schaltungsträgers 20 verbunden, welcher über Bonddraht 9 mit einem auf der ersten Seite 20.1 bzw. Oberseite angeordneten und als Logikschaltkreis 5A ausgeführten elektronischen Bauteil 5 verbunden ist. Der Logikschaltkreis 5A ist über einen weiteren Bonddraht 9 mit einer elektrisch leitenden Leitungsstruktur kontaktiert. Wie aus Fig. 2 bis 4 weiter ersichtlich ist, sind auf der ersten Seite 20.1 bzw. Oberseite noch weitere als diskrete Bauteile 5B ausgeführte elektronische Bauteile 5 angeordnet und mit korrespondierenden elektrisch leitenden Leitungsstrukturen kontaktiert. Des Weiteren ist in den dargestellten Ausführungsbeispielen jeweils eine Hochstromleiterbahn 28A in den mehrlagigen LTCC-Schaltungsträger 20 eingebettet und über mindestens eine erste Durchkontaktierung 27.1 mit einem korrespondierenden Anschlusskontakt auf der ersten Seite 20.1 bzw. Oberseite oder auf der zweiten Seite 20.2 bzw. Unterseite des mehrlagigen LTCC-Schaltungsträgers 20 elektrisch verbunden ist.

Wie aus Fig. 2 weiter ersichtlich ist, schließt der dargestellte SiC-Leistungshalbleiter 7 mit seiner als flächige Metallisierung ausgeführten zweiten Seite 7.2 bzw. Rückseite bündig mit der zweiten Seite 20.2 bzw. Rückseite des LTCC-Schaltungsträgers 20 ab. Des Weiteren ist die Hochstromleiterbahn 28A im dargestellten ersten Ausführungsbeispiel des elektronischen Schaltungsmoduls 1A über mehrere erste Durchkontaktierungen 27.1 mit korrespondierenden Anschlusskontakten auf der zweiten Seite 20.2 bzw. Unterseite des mehrlagigen LTCC-Schaltungsträgers 20 elektrisch verbunden. Zudem ist die Hochstromleiterbahn 28A über mehrere zweite Durchkontaktierungen 27.2 mit einem korrespondierenden Anschlusskontakt auf der ersten Seite 7.1 bzw. Oberseite des mindestens einen SiC-Leistungshalbleiters 7 elektrisch verbunden.

Wie aus Fig. 3 weiter ersichtlich ist, ist der dargestellte SiC-Leistungshalbleiter 7 an allen vier Seiten von dem mehrlagigen LTCC-Schaltungsträger 20 umschlossen und damit vollständig in LTCC-Schaltungsträger 20 integriert. Des Weiteren ist die Hochstromleiterbahn 28A im dargestellten zweiten Ausführungsbeispiel des elektronischen Schaltungsmoduls 1B über mehrere erste Durchkontaktierungen 27.1 mit korrespondierenden Anschlusskontakten auf der zweiten Seite 20.2 bzw. Unterseite des mehrlagigen LTCC-Schaltungsträgers 20 elektrisch verbunden. Zudem ist die Hochstromleiterbahn 28A über mehrere zweite Durchkontaktierungen 27.2 mit einem korrespondierenden Anschlusskontakt auf der ersten Seite 7.1 bzw. Oberseite des mindestens einen SiC-Leistungshalbleiters 7 elektrisch verbunden. Die als flächige Metallisierung ausgeführte zweite Seite 7.2 bzw. Rückseite des SiC-Leistungshalbleiters 7 ist über mehrere Durchkontaktierungen 26 mit entsprechenden Anschlusskontakten auf der zweiten Seite 20.2 bzw. Rückseite des LTCC-Schaltungsträgers 20 verbunden.

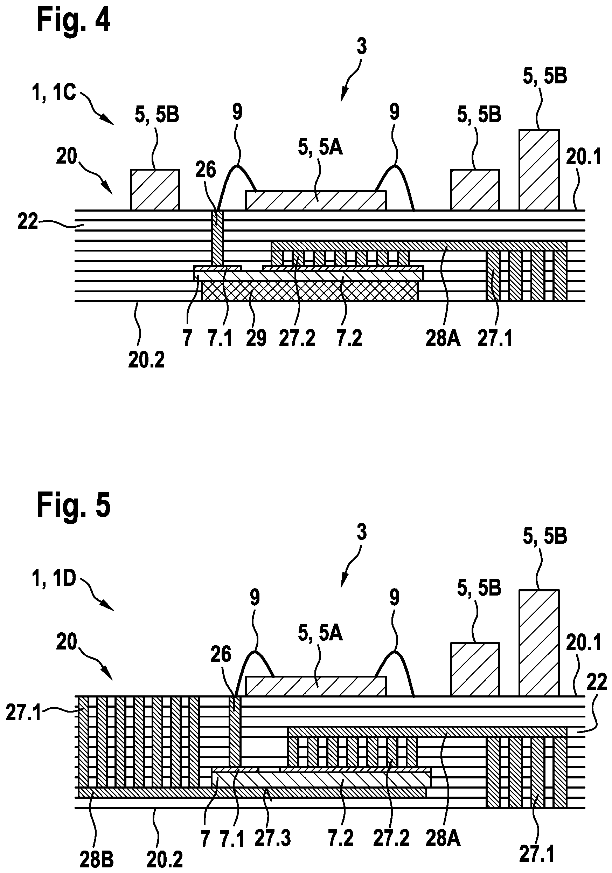

Wie aus Fig. 4 weiter ersichtlich ist, ist der dargestellte SiC-Leistungshalbleiter 7 an drei Seiten von dem mehrlagigen LTCC-Schaltungsträger 20 umschlossen, wobei die als flächige Metallisierung ausgeführte zweite Seite 7.2 bzw. Rückseite des SiC-Leistungshalbleiters 7 flächig mit einer thermisch und elektrisch leitenden gedruckten Dickschichtstruktur 29 kontaktiert ist. Das Dickschichtstruktur 29 schließt bündig mit der zweiten Seite 20.2 bzw. Rückseite des mehrlagigen LTCC-Schaltungsträgers 20 ab. Die Hochstromleiterbahn 28A ist im dargestellten dritten Ausführungsbeispiel des elektronischen Schaltungsmoduls 1C über mehrere erste Durchkontaktierungen 27.1 mit korrespondierenden Anschlusskontakten auf der zweiten Seite 20.2 bzw. Unterseite des mehrlagigen LTCC-Schaltungsträgers 20 elektrisch verbunden. Zudem ist die Hochstromleiterbahn 28A über mehrere zweite Durchkontaktierungen 27.2 mit einem korrespondierenden Anschlusskontakt auf der ersten Seite 7.1 bzw. Oberseite des mindestens einen SiC-Leistungshalbleiters 7 elektrisch verbunden. Bei einem alternativen nicht dargestellten Ausführungsbeispiel ist die zweite Seite 7.2 bzw. Rückseite des SiC-Leistungshalbleiters 7 anstelle mit der gedruckten Dickschichtstruktur 29 flächig mit einem thermisch und elektrisch leitenden Einlegeteil kontaktiert.

Wie aus Fig. 5 weiter ersichtlich ist, ist der dargestellte SiC-Leistungshalbleiter 7 an allen vier Seiten von dem mehrlagigen LTCC-Schaltungsträger 20 umschlossen, wobei die als flächige Metallisierung ausgeführte zweite Seite 7.2 bzw. Rückseite des SiC-Leistungshalbleiters 7 flächig mit einer Kontaktfläche 27.3 einer weiteren Hochstromleiterbahn 28B kontaktiert ist, welche über mehrere erste Durchkontaktierungen 27.1 mit entsprechenden Anschlusskontakten auf der ersten Seite 20.1 bzw. Oberseite des LTCC-Schaltungsträgers 20 kontaktiert ist. Die Hochstromleiterbahn 28A ist im dargestellten dritten Ausführungsbeispiel des elektronischen Schaltungsmoduls 1C über mehrere erste Durchkontaktierungen 27.1 mit korrespondierenden Anschlusskontakten auf der zweiten Seite 20.2 bzw. Unterseite des mehrlagigen LTCC-Schaltungsträgers 20 elektrisch verbunden. Zudem ist die Hochstromleiterbahn 28A über mehrere zweite Durchkontaktierungen 27.2 mit einem korrespondierenden Anschlusskontakt auf der ersten Seite 7.1 bzw. Oberseite des mindestens einen SiC-Leistungshalbleiters 7 elektrisch verbunden.

Durch den hohen Druck während des druckunterstützten Sinterprozesses fließt ein Teil der Rohsubstratlage 12 in die letzten Hohlräume der Aussparung 24, so dass der mindestens eine SiC-Leistungshalbleiter 7 in den dargestellten Ausführungsbeispielen in den mehrlagigen LTCC-Schaltungsträger 20 eingebettet wird, wie aus Fig. 1 d) und 2 bis 5 ersichtlich ist. Bei diesem Einbetten kommen die elektrischen und/oder thermischen Leitungsstrukturen, die Hochstromleiterbahnen 28A, 28B und die Durchkontaktierungen 26, 27.1, 27.2 sowie die Anschlusskontakte des mindestens einen SiC-Leistungshalbleiters 7 in Berührung miteinander. Bei 900°C sintern die einzelnen strukturierten anorganischen Substratlagen 22 des LTCC-Schaltungsträger 20 und auch das für die elektrischen und/oder thermischen Leitungsstrukturen und Leiterbahnen und Durchkontaktierungen verwendete Silber. Dabei kommt es auch zum Versintern des Silbers mit den metallischen Kontakten des mindestens einen SiC-Leistungshalbleiters 7 und eine stabile elektrische Verbindung mit ohmschen Kontakten entsteht.

## Patentansprüche

1. Elektronisches Schaltungsmodul (1) mit einem mehrlagigen LTCC-Schaltungsträger (20) aus strukturierten anorganischen Substratlagen (22), welche zur elektrischen und/oder thermischen Leitung elektrische und/oder thermische Leitungsstrukturen aufweisen, mindestens einem elektronischen Bauteil (5), welches auf einer ersten Seite (20.1) und/oder einer gegenüberliegenden zweiten Seite (20.2) des LTCC-Schaltungsträgers (20) angeordnet ist, und mindestens einem SiC-Leistungshalbleiter (7), wobei der mindestens eine SiC-Leistungshalbleiter (7) in den mehrlagigen LTCC-Schaltungsträger (20) eingebettet und zumindest an drei Seiten von dem mehrlagigen LTCC-Schaltungsträger (20) umschlossen ist, wobei Anschlusskontakte des SiC-Leistungshalbleiter (7) mit den elektrischen und/oder thermischen Leitungsstrukturen des LTCC-Schaltungsträgers (20) kontaktiert sind, wobei eine erste Seite (7.1) des mindestens einen SiC-Leistungshalbleiters (7) einer ersten Seite (20.1) des mehrlagigen LTCC-Schaltungsträgers (20) zugewandt ist, und eine zweite Seite (7.2) des mindestens einen SiC-Leistungshalbleiters (7) einer zweiten Seite (20.2) des mehrlagigen LTCC-Schaltungsträgers (20) zugewandt ist, und **dadurch gekennzeichnet, dass** die erste Seite (7.1) bündig mit der ersten Seite (20.1) des mehrlagigen LTCC-Schaltungsträgers (20) abschließt oder die zweite Seite (7.2) des mindestens einen SiC-Leistungshalbleiters (7) bündig mit der zweiten Seite (20.2) des mehrlagigen LTCC-Schaltungsträgers (20) abschließt.

2. Elektronisches Schaltungsmodul (1) nach Anspruch 1, **dadurch gekennzeichnet, dass** der mindestens eine SiC-Leistungshalbleiter (7) eine korrespondierende Aussparung (24) ausfüllt, welche in mindestens eine anorganische Substratlage (22) eingebracht ist.

3. Elektronisches Schaltungsmodul (1) nach Anspruch 1 oder 2, **dadurch gekennzeichnet, dass** mindestens ein Anschlusskontakt auf der ersten Seite (7.1) oder auf der zweiten Seite (7.2) des mindestens einen SiC-Leistungshalbleiters (7) über eine Durchkontaktierung (26) elektrisch mit einem Anschlusskontakt, welcher auf der ersten Seite (20.1) oder auf der zweiten Seite (20.2) des mehrlagigen LTCC-Schaltungsträgers (20) angeordnet ist, oder mit einem elektronischen Bauteil (5) verbunden ist, welches auf der ersten Seite (20.1) oder auf der zweiten Seite (20.2) des mehrlagigen LTCC-Schaltungsträgers (20) angeordnet ist.

4. Elektronisches Schaltungsmodul (1) nach einem der Ansprüche 1 bis 3, **dadurch gekennzeichnet, dass** eine Hochstromleiterbahn (28A, 28B) in den mehrlagigen LTCC-Schaltungsträger (20) eingebettet und über mindestens eine erste Durchkontaktierung (27.1) mit einem korrespondierenden Anschlusskontakt auf der ersten Seite (20.1) oder auf der zweiten Seite (20.2) des mehrlagigen LTCC-Schaltungsträgers (20) elektrisch verbunden ist.

5. Elektronisches Schaltungsmodul (1) nach Anspruch 4, **dadurch gekennzeichnet, dass** die Hochstromleiterbahn (28A) über mindestens eine zweite Durchkontaktierung (27.2) mit einem korrespondierenden Anschlusskontakt auf der ersten Seite (7.1) oder auf der zweiten Seite (7.2) des mindestens einen SiC-Leistungshalbleiters (7) elektrisch verbunden ist.

6. Elektronisches Schaltungsmodul (1) nach Anspruch 4, **dadurch gekennzeichnet, dass** die Hochstromleiterbahn (28B) über eine Kontaktfläche (27.3) flächig mit einem korrespondierenden Anschlusskontakt auf der ersten Seite (7.1) oder auf der zweiten Seite (7.2) des mindestens einen SiC-Leistungshalbleiters (7) elektrisch verbunden ist.

7. Elektronisches Schaltungsmodul (1) nach einem der Ansprüche 1 bis 6, **dadurch gekennzeichnet, dass** ein Anschlusskontakt auf der ersten Seite (7.1) oder auf der zweiten Seite (7.2) des mindestens einen SiC-Leistungshalbleiters (7) flächig mit einem thermisch und elektrisch leitenden Einlegeteil oder mit einer thermisch und elektrisch leitenden gedruckten Dickschichtstruktur (29) kontaktiert ist, wobei das Einlegeteil oder die Dickschichtstruktur (29) bündig mit der ersten Seite (20.1) oder mit der zweiten Seite (20.2) des mehrlagigen LTCC-Schaltungsträgers (20) abschließt.

8. Elektronisches Schaltungsmodul (1) nach einem der Ansprüche 1 bis 7, **dadurch gekennzeichnet, dass** der mindestens eine SiC-Leistungshalbleiter (7) als MOSFET-Leistungsschalter ausgebildet ist.

9. Verfahren zur Herstellung eines mehrlagigen LTCC-Schaltungsträgers (20) für das elektronische Schaltungsmodul (1), welches nach einem der Ansprüche 1 bis 8 ausgebildet ist, wobei in mindestens eine Rohsubstratlage (12) mit elektrischen und/oder thermischen Leitungsstrukturen mindestens eine Aussparung (14) für einen korrespondierenden SiC-Leistungshalbleiter (7) eingebracht wird, wobei mehrere Rohsubstratlagen (12) gestapelt und mindestens ein SiC-Leistungshalbleiter (7) in die mindestens eine Aussparung (14) eingelegt wird, wobei der Rohsubstratstapel (10) mit dem SiC-Leistungshalbleiter (7) unter Druck und Temperatur laminiert wird, und wobei der laminierte Rohsubstratstapel (10A) in einem druckunterstützten Sinterprozess zu dem mehrlagigen LTCC-Schaltungsträger (20) mit dem eingebetteten SiC-Leistungshalbleiter (7) geschrumpft wird, wobei Anschlusskontakte des SiC-Leistungshalbleiters (7) durch den druckunterstützten Sinterprozess mit den elektrischen und/oder thermischen Leitungsstrukturen von anorganischen Substratlagen (22) kontaktiert werden, welche durch den druckunterstützten Sinterprozess aus den Rohsubstratlagen (12) mit elektrischen und/oder thermischen Leitungsstrukturen erzeugt werden.

10. Verfahren nach Anspruch 9, **dadurch gekennzeichnet, dass** vor dem Stapeln der Rohsubstratlagen (12) mindestens eine weitere Aussparung in mindestens eine Rohsubstratlage (12) eingebracht wird, in welche während oder nach dem Stapeln mindestens eine Durchkontaktierung (26, 27.1, 27.2) und/oder mindestens eine Hochstromleiterbahn (28A, 28B) und/oder mindestens ein thermisch und elektrisch leitendes Einlegeteil als zusätzliche elektrische Leitungsstruktur eingelegt und/oder mindestens eine thermisch und elektrisch leitende Dickschichtstruktur (29) als zusätzliche elektrische Leitungsstruktur gedruckt wird.

11. Verfahren nach Anspruch 9 oder 10, **dadurch gekennzeichnet, dass** der druckunterstützte Sinterprozess die Rohsubstratlage (12) in der Dicke schrumpft, so dass die erzeugte Substratlage (22) dünner als die Rohsubstratlage (12) ist.

12. Verfahren nach einem der Ansprüche 9 bis 11, **dadurch gekennzeichnet, dass** eine Höhe einer Aussparung (14), welche in mindestens eine der Rohsubstratlagen (12) eingebracht wird, höher als der SiC-Leistungshalbleiter (7) ausgeführt wird, wobei die Höhe der Aussparung (14) in der mindestens einen Rohsubstratlage (12) so gewählt wird, dass die Höhe einer geschrumpften Aussparung (24) in der mindestens einen geschrumpften Substratlage (22) der Höhe des SiC-Leistungshalbleiters (7) entspricht und der mindestens eine SiC-Leistungshalbleiter (7) die korrespondierende geschrumpfte Aussparung (24) ausfüllt.

## Claims

1. Electronic circuit module (1) with a multilayer LTCC circuit carrier (20) consisting of structured inorganic substrate layers (22), which have electrical and/or thermal conduction structures for electrical and/or thermal conduction, at least one electronic component (5) that is arranged on a first side (20.1) and/or an opposite second side (20.2) of the LTCC circuit carrier (20), and at least one SiC power semiconductor (7), wherein the at least one SiC power semiconductor (7) is embedded in the multilayer LTCC circuit carrier (20) and is enclosed at least on three sides by the multilayer LTCC circuit carrier (20), wherein connection contacts of the SiC power semiconductor (7) make contact with the electrical and/or thermal conduction structures of the LTCC circuit carrier (20), wherein a first side (7.1) of the at least one SiC power semiconductor (7) faces a first side (20.1) of the multilayer LTCC circuit carrier (20), and a second side (7.2) of the at least one SiC power semiconductor (7) faces a second side (20.2) of the multilayer LTCC circuit carrier (20), and **characterized in that**
the first side (7.1) terminates flush with the first side (20.1) of the multilayer LTCC circuit carrier (20) or the second side (7.2) of the at least one SiC power semiconductor (7) terminates flush with the second side (20.2) of the multilayer LTCC circuit carrier (20).

2. Electronic circuit module (1) according to Claim 1, **characterized in that** the at least one SiC power semiconductor (7) fills a corresponding recess (24) that is introduced into at least one inorganic substrate layer (22).

3. Electronic circuit module (1) according to Claim 1 or 2, **characterized in that** at least one connection contact on the first side (7.1) or on the second side (7.2) of the at least one SiC power semiconductor (7) is electrically connected by way of a via (26) to a connection contact that is arranged on the first side (20.1) or on the second side (20.2) of the multilayer LTCC circuit carrier (20), or is connected to an electronic component (5) that is arranged on the first side (20.1) or on the second side (20.2) of the multilayer LTCC circuit carrier (20).

4. Electronic circuit module (1) according to one of Claims 1 to 3, **characterized in that** a high-current conductor track (28A, 28B) is embedded in the multilayer LTCC circuit carrier (20) and is electrically connected by way of at least one first via (27.1) to a corresponding connection contact on the first side (20.1) or on the second side (20.2) of the multilayer LTCC circuit carrier (20).

5. Electronic circuit module (1) according to Claim 4, **characterized in that** the high-current conductor track (28A) is electrically connected by way of at least one second via (27.2) to a corresponding connection contact on the first side (7.1) or on the second side (7.2) of the at least one SiC power semiconductor (7).

6. Electronic circuit module (1) according to Claim 4, **characterized in that** the high-current conductor track (28B) is electrically connected by way of a contact surface (27.3) to a corresponding connection contact on the first side (7.1) or on the second side (7.2) of the at least one SiC power semiconductor (7) in an areal manner.

7. Electronic circuit module (1) according to one of Claims 1 to 6, **characterized in that** a connection contact on the first side (7.1) or on the second side (7.2) of the at least one SiC power semiconductor (7) makes contact with a thermally and electrically conductive insert or with a thermally and electrically conductive printed thick-film structure (29) in an areal manner, wherein the insert or the thick-film structure (29) terminates flush with the first side (20.1) or with the second side (20.2) of the multilayer LTCC circuit carrier (20).

8. Electronic circuit module (1) according to one of Claims 1 to 7, **characterized in that** the at least one SiC power semiconductor (7) is in the form of a MOSFET power switch.

9. Method for producing a multilayer LTCC circuit carrier (20) for the electronic circuit module (1), which is designed according to one of Claims 1 to 8, wherein at least one recess (14) for a corresponding SiC power semiconductor (7) is introduced into at least one raw substrate layer (12) with electrical and/or thermal conduction structures, wherein a plurality of raw substrate layers (12) are stacked and at least one SiC power semiconductor (7) is inserted into the at least one recess (14), wherein the raw substrate stack (10) is laminated with the SiC power semiconductor (7) under the action of pressure and temperature, and wherein the laminated raw substrate stack (10A) is shrunk in a pressure-assisted sintering process to form the multilayer LTCC circuit carrier (20) with the embedded SiC power semiconductor (7), wherein connection contacts of the SiC power semiconductor (7) make contact with the electrical and/or thermal conduction structures of inorganic substrate layers (22) as a result of the pressure-assisted sintering process, which inorganic substrate layers are produced by way of the pressure-assisted sintering process from the raw substrate layers (12) with electrical and/or thermal conduction structures.

10. Method according to Claim 9, **characterized in that**, before the stacking of the raw substrate layers (12), at least one further recess is introduced into at least one raw substrate layer (12), into which, during or after the stacking, at least one via (26, 27.1, 27.2) and/or at least one high-current conductor track (28A, 28B) and/or at least one thermally and electrically conductive insert is inserted as an additional electrical conduction structure and/or at least one thermally and electrically conductive thick-film structure (29) is printed as an additional electrical conduction structure.

11. Method according to Claim 9 or 10, **characterized in that** the pressure-assisted sintering process shrinks the raw substrate layer (12) in terms of thickness, with the result that the produced substrate layer (22) is thinner than the raw substrate layer (12).

12. Method according to one of Claims 9 to 11, **characterized in that** a height of a recess (14) that is introduced into at least one of the raw substrate layers (12) is designed to be higher than the SiC power semiconductor (7), wherein the height of the recess (14) in the at least one raw substrate layer (12) is selected in such a way that the height of a shrunk recess (24) in the at least one shrunk substrate layer (22) corresponds to the height of the SiC power semiconductor (7) and the at least one SiC power semiconductor (7) fills the corresponding shrunk recess (24).

## Revendications

1. Module de circuit électronique (1) comprenant un support de circuit LTCC multicouche (20) constitué de couches de substrats inorganiques structurées (22) qui présentent des structures de conduction électrique et/ou thermique pour la conduction électrique et/ou thermique, au moins un composant électronique (5) qui est disposé sur un premier côté (20.1) et/ou un second côté opposé (20.2) du support de circuit LTCC (20); et au moins un semi-conducteur de puissance SiC (7), ledit au moins un semi-conducteur de puissance SiC (7) étant intégré dans le support de circuit LTCC multicouche (20) et entouré sur au moins trois côtés par le support de circuit LTCC multicouche (20), des contacts de connexion du semi-conducteur de puissance SiC (7) étant en contact avec les structures de conduction électrique et/ou thermique du support de circuit LTCC (20), un premier côté (7.1) dudit au moins un semi-conducteur de puissance SiC (7) faisant face à un premier côté (20.1) du support de circuit multicouche LTCC (20), et un second côté (7.2) dudit au moins un semi-conducteur de puissance SiC (7) faisant face à un second côté (20.2) du support de circuit multicouche LTCC (20), et **caractérisé en ce que**
le premier côté (7.1) se termine en affleurement avec le premier côté (20.1) du support de circuit multicouche LTCC (20) ou **en ce que** le second côté (7.2) dudit au moins un semi-conducteur de puissance SiC (7) se termine en affleurement avec le second côté (20.2) du support de circuit multicouche LTCC (20).

2. Module de circuit électronique (1) selon la revendication 1, **caractérisé en ce que** ledit au moins un semi-conducteur de puissance SiC (7) remplit un évidement correspondant (24), lequel est ménagé dans au moins une couche de substrat inorganique (22).

3. Module de circuit électronique (1) selon la revendication 1 ou 2, **caractérisé en ce qu'**au moins un contact de connexion situé sur le premier côté (7.1) ou sur le second côté (7.2) dudit au moins un semi-conducteur de puissance SiC (7) est relié électriquement, par l'intermédiaire d'un trou d'interconnexion (26), à un contact de connexion disposé sur le premier côté (20.1) ou sur le second côté (20.2) du support de circuit LTCC multicouche (20), ou à un composant électronique (5) disposé sur le premier côté (20.1) ou sur le second côté (20.2) du support de circuit LTCC multicouche (20).

4. Module de circuit électronique (1) selon l'une quelconque des revendications 1 à 3, **caractérisé en ce qu'**une piste conductrice à courant fort (28A, 28B) est intégrée dans le support de circuit LTCC multicouche (20) et est reliée électriquement, par l'intermédiaire d'au moins un premier trou d'interconnexion (27.1), à un contact de connexion correspondant situé sur le premier côté (20.1) ou sur le second côté (20.2) du support de circuit multicouche LTCC (20).

5. Module de circuit électronique (1) selon la revendication 4, **caractérisé en ce que** la piste conductrice à courant fort (28A) est reliée électriquement, par l'intermédiaire d'au moins un second trou d'interconnexion (27.2), à un contact de connexion correspondant situé sur le premier côté (7.1) ou sur le second côté (7.2) dudit au moins un semi-conducteur de puissance SiC (7).

6. Module de circuit électronique (1) selon la revendication 4, **caractérisé en ce que** la piste conductrice à courant fort (28B) est reliée électriquement, par l'intermédiaire d'une surface de contact (27.3), à un contact de connexion correspondant situé sur le premier côté (7.1) ou sur le second côté (7.2) dudit au moins un semi-conducteur de puissance SiC (7).

7. Module de circuit électronique (1) selon l'une quelconque des revendications 1 à 6, **caractérisé en ce qu'**un contact de connexion situé sur le premier côté (7.1) ou sur le second côté (7.2) dudit au moins un semi-conducteur de puissance SiC (7) est en contact avec une pièce d'insertion thermiquement et électriquement conductrice, ou avec une structure en couche épaisse imprimée (29) thermiquement et électriquement conductrice, ladite pièce d'insertion ou ladite structure en couche épaisse (29) se terminant en affleurement avec le premier côté (20.1) ou avec le second côté (20.2) du support de circuit multicouche LTCC (20).

8. Module de circuit électronique (1) selon l'une quelconque des revendications 1 à 7, **caractérisé en ce que** ledit au moins un semi-conducteur de puissance SiC (7) est réalisé sous forme de commutateur de puissance MOSFET.

9. Procédé de fabrication d'un support de circuit LTCC multicouche (20) pour le module de circuit électronique (1), conçu selon l'une quelconque des revendications 1 à 8, au moins un évidement (14) pour un semi-conducteur de puissance SiC (7) correspondant étant ménagé dans au moins une couche de substrat brute (12) dotée de structures de conduction électrique et/ou thermique, plusieurs couches de substrat brutes (12) étant empilées et au moins un semi-conducteur de puissance SiC (7) étant inséré dans ledit au moins un évidement (14), l'empilement de substrats bruts (10) étant stratifié sous pression et à température avec le semi-conducteur de puissance SiC (7), et l'empilement de substrats bruts stratifié (10A) étant rétréci lors d'un processus de frittage assisté par pression pour obtenir le support de circuit LTCC multicouche (20) avec le semi-conducteur de puissance SiC (7) intégré, les contacts de connexion du semi-conducteur de puissance SiC (7) étant mis en contact, par le processus de frittage assisté par pression, avec les structures de conduction électrique et/ou thermique des substrats inorganiques (22), lesquelles sont produites à partir des couches de substrat brutes (12) dotées de structures de conduction électrique et/ou thermique par le processus de frittage assisté par pression.

10. Procédé selon la revendication 9, **caractérisé en ce que**, avant l'empilage des couches de substrat brutes (12), au moins un évidement supplémentaire est ménagé dans au moins une couche de substrat brute (12), dans lequel sont placés, pendant ou après l'empilage, au moins un trou d'interconnexion (26, 27.1, 27.2) et/ou au moins une piste conductrice à courant fort (28A, 28B) et/ou au moins une pièce d'insertion thermiquement et électriquement conductrice en tant que structure de conduction électrique supplémentaire et/ou au moins une structure en couche épaisse (29) thermiquement et électriquement conductrice est imprimée en tant que structure de conduction électrique supplémentaire.

11. Procédé selon la revendication 9 ou 10, **caractérisé en ce que** le processus de frittage assisté par pression fait rétrécir la couche de substrat brute (12) en épaisseur, de sorte que la couche de substrat produite (22) est plus fine que la couche de substrat brute (12).

12. Procédé selon l'une quelconque des revendications 9 à 11, **caractérisé en ce qu'**une hauteur d'un évidement (14) ménagé dans au moins l'une des couches de substrat brutes (12) est supérieure à celle du semi-conducteur de puissance SiC (7), la hauteur de l'évidement (14) dans ladite au moins une couche de substrat brute (12) étant choisie de manière à ce que la hauteur d'un évidement rétréci (24) dans ladite au moins une couche de substrat rétrécie (22) corresponde à la hauteur du semi-conducteur de puissance SiC (7), et **en ce que** ledit au moins un semi-conducteur de puissance SiC (7) remplit l'évidement rétréci (24) correspondant.
